# EUROPEAN PATENT APPLICATION

(11) **EP 3 806 613 A1**
(43) Date of publication of application: **14.04.2021**
(21) Application number: 18920908.3
(22) Date of filing: 01.06.2018
(51) Int. Cl.: H05K 13/04

(54) **COMPONENT MOUNTING MACHINE**

(71) Applicant: Fuji Corporation, Chiryu-shi, Aichi 472-8686 (JP)
(72) Inventor: ITO, Hidetoshi, Chiryu-shi, Aichi 472-8686 (JP); ISHIKAWA, Kenzo, Chiryu-shi, Aichi 472-8686 (JP)
(74) Representative: Grünecker Patent- und Rechtsanwälte PartG mbB
(86) International application number: PCT/JP2018/021257
(87) International publication number: WO 2019/229991

(57) **Abstract**

A component mounting machine includes a first moving body which is provided to be relatively movable with respect to a base in a first direction of a horizontal direction, and a second moving body having a mounting head holding a component to be mounted on a board. The mounting head includes a lifting and lowering device which lifts and lowers a holding member angled to a predetermined angle around R-axis by rotation of a rotary head, and is provided on a head main body such that a centroid position of the lifting and lowering device is located between R-axis and a support section in which the first moving body supports the second moving body such as to be relatively movable.

## Description

### Technical Field

The present invention relates to a component mounting machine.

### Background Art

A component mounting machine executes a mounting process of mounting a component on a board by using a mounting head. The mounting head constitutes a moving body which is movably provided in a horizontal direction within a mounter of the component mounting machine. Patent Literature 1 discloses a mounting head having a rotary head for supporting multiple suction nozzles for holding a component. The mounting head includes a lifting and lowering device for lifting and lowering the suction nozzles at a predetermined angle around a rotation axis of the rotary head.

### Patent Literature

Patent Literature 1: JP-A-2014-183168

### Summary of the Invention

### Technical Problem

In the component mounting machine as described above, vibration occurs when the suction nozzle is lifted and lowered in the mounting head. If vibration occurs in the mounting head, an accuracy of a mounting process and a required time may be affected. Therefore, in the component mounting machine, it is desired to suppress the occurrence of vibration associated with an operation of the lifting and lowering device in the mounting head.

An object of the present specification is to provide a component mounting machine capable of suppressing the occurrence of vibration associated with an operation of the lifting and lowering device.

### Solution to Problem

The present specification discloses a first component mounting machine including: a base;
a first moving body which is provided to be relatively movable with respect to the base in a first direction of a horizontal direction; and a second moving body, a side surface of which in the first direction being supported by the first moving body, which is capable of being relatively movable with respect to the first moving body in a second direction of the horizontal direction intersecting with the first direction, and which has a mounting head holding a component to be mounted on a board, wherein the mounting head includes
a head main body provided on the second moving body, a rotary head being rotatably provided around an R-axis parallel with a vertical axis with respect to the head main body, the rotary head being configured to support multiple holding members, each of which being capable of holding the component and being lifted and lowered with respect to the head main body, and a lifting and lowering device which lifts and lowers the holding member angled to a predetermined angle around the R-axis by rotation of the rotary head, the lifting and lowering device being provided on the head main body such that a centroid position of the lifting and lowering device is located between the R-axis and a support section in which the first moving body supports the second moving body in a manner of moving relatively.

The present specification discloses a second component mounting machine including: a base; a first moving body which is provided to be relatively movable with respect to the base in a first direction of a horizontal direction; and a second moving body, a side surface of which in the first direction being supported by the first moving body, which is capable of being relatively movable with respect to the first moving body in a second direction of the horizontal direction intersecting with the first direction, and which has a mounting head holding a component to be mounted on a board, wherein the mounting head includes
a head main body provided on the second moving body, a rotary head being rotatably provided around an R-axis parallel with a vertical axis with respect to the head main body, the rotary head being configured to support multiple holding members, each of which being capable of holding the component and being lifted and lowered with respect to the head main body, and a lifting and lowering device which lifts and lowers the holding member angled to a predetermined angle around the R-axis by rotation of the rotary head by operating a movable section which relatively moves or relatively rotates with respect to the head main body, the lifting and lowering device being provided on the head main body such that the movable section is located between the R-axis and a support section in which the first moving body supports the second moving body in a manner of moving relatively.

### Advantageous Effect of the Invention

A magnitude of the vibration occurring associated with the operation of the lifting and lowering device changes depending on a positional relationship between the support section which supports the second moving body including the mounting head in the first moving body and the centroid position of the mounting head. Here, the lifting and lowering device is a heavy object occupying a large weight ratio in the mounting head. Whereas, according to the above-described configuration, inevitably the centroid position of the mounting head is close to the support section. Thus, it is possible to suppress the vibration occurring associated with the operation of the lifting and lowering device.

### Brief Description of Drawings

Fig. 1 is a perspective view illustrating a component mounting machine in an embodiment.
Fig. 2 is a side view schematically illustrating a mounting head.
Fig. 3 is a plan view schematically illustrating the mounting head.
Fig. 4 is a side view schematically illustrating a mounting head in Modified Examples of the embodiment.

### Description of Embodiments

### 1. Configuration of Component Mounter 1

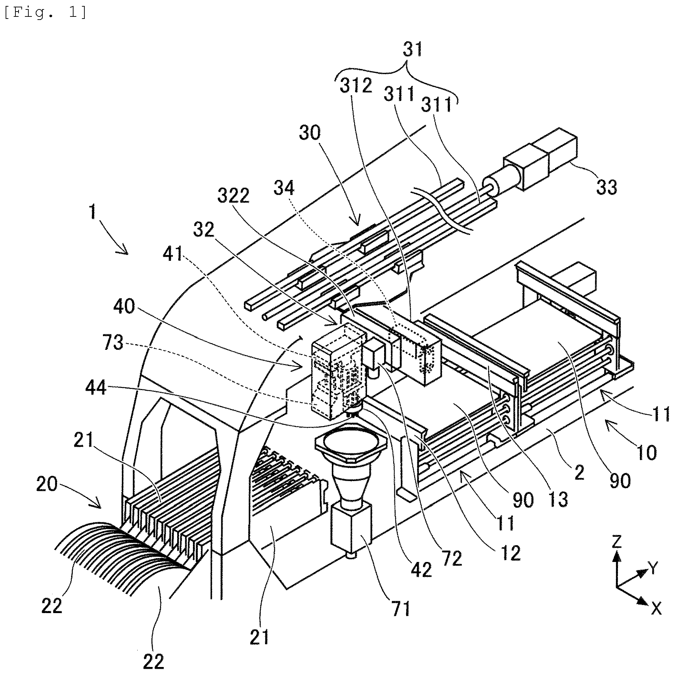

As illustrated in Fig. 1, component mounting machine 1 includes board conveyance device 10, component supply device 20, component transfer device 30, part camera 71, board camera 72, and head camera unit 73. In the following description, a first direction of the horizontal direction and a front-rear direction (direction from lower left to upper right in Fig. 1) of component mounting machine 1 is referred to as Y-direction, a second direction of the horizontal direction intersecting with Y-direction and a left-right direction (direction from upper left to lower right in Fig. 1) of component mounting machine 1 is referred to as X-direction, and a vertical direction (up-down direction in Fig. 1) orthogonal to X-direction and Y-direction is referred to as Z-direction.

Board conveyance device 10 is constituted by multiple conveyance mechanisms 11 which are disposed side by side in Y-direction, and the like. Conveyance mechanism 11 has a pair of guide rails 12 and 13. The pair of guide rails 12 and 13 guide board 90 which is placed on a conveyor belt to be conveyed. Board conveyance device 10 subsequently conveys board 90 in the conveyance direction, and positions board 90 at a predetermined position within the mounter. Board conveyance device 10 conveys out board 90 to an outside of the mounter of component mounting machine 1 after a mounting process of the component by component mounting machine 1 is completed.

Component supply device 20 supplies the component to be mounted on board 90. Component supply device 20 includes feeders 21 set side by side in X-direction. Feeder 21 holds reel 22 on which a carrier tape where multiple number of components are stored is wound. Feeder 21 moves the carrier tape fed out from reel 22. Thus, feeder 21 supplies the component to be capable of picking up in a supply position located on a distal end side of feeder 21.

Component transfer device 30 transfers the component supplied by component supply device 20 to a predetermined mounting position on board 90 conveyed in the mounter by board conveyance device 10. Component transfer device 30 includes Y-slide device 31, X-slide device 32, Y-driving section 33, X-driving section 34, and mounting head 40. Y-slide device 31 moves mounting head 40 in the front-rear direction (Y-direction) of base 2. Y-slide device 31 has a pair of Y-rails 311 and Y-slider 312. The pair of Y-rails 311 extend in the front-rear direction of base 2 and are disposed in parallel with each other.

Y-slider 312 slidably engages with the pair of Y-rails 311. Y-slider 312 is configured to be movable in the front-rear direction of base 2 in a state of being suspended by the pair of Y-rails 311. As described above, Y-slide device 31 is a suspension type having the pair of Y-rails 311 for supporting Y-slider 312 in a state of being suspended. Thus, component transfer device 30 can secure a large movable range in the left-right direction (X-direction) of mounting head 40. Y-slider 312 is moved by Y-driving section 33 to a predetermined position in Y-direction. For example, a linear motion mechanism using a ball screw mechanism and a linear motor is applied to Y-driving section 33.

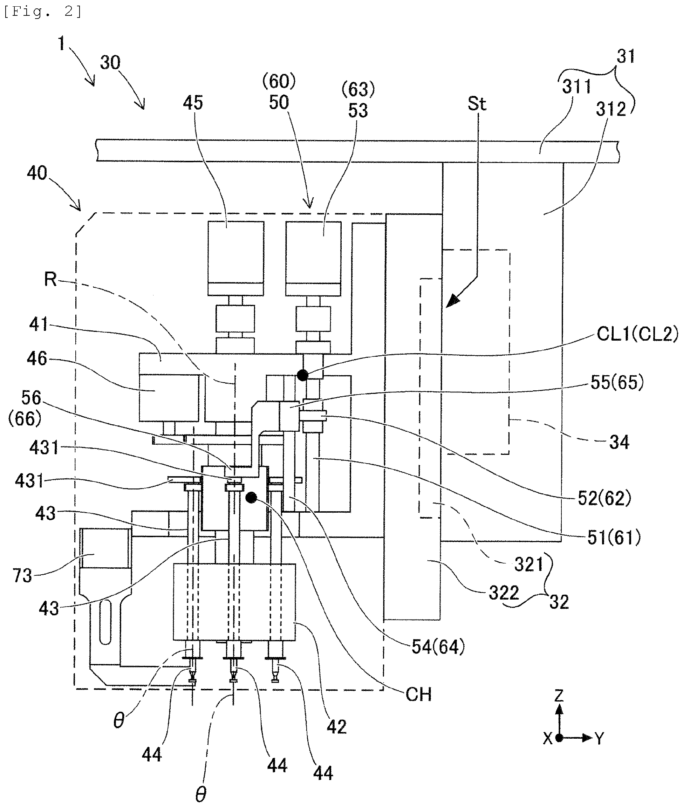

X-slide device 32 moves mounting head 40 in the left-right direction (X-direction) of base 2. As illustrated in Fig. 2, X-slide device 32 has X-rail 321 and X-slider 322. X-rail 321 is formed to extend in X-direction. X-rail 321 is disposed on a side surface of Y-slider 312 in Y-direction. X-slider 322 slidably engages with X-rail 321. X-slider 322 is moved by X-driving section 34 to a predetermined position in X-direction. For example, a linear motion mechanism using a ball screw mechanism and a linear motor is applied to X-driving section 34.

Mounting head 40 holds the component to be mounted on board 90 by using one or multiple holding members. Mounting head 40 is detachably fixed to X-slider 322 by a clamp (not illustrated). Further, as the holding member described above, for example, a suction nozzle for picking up the component by negative pressure air, a chuck for clamping the component, or the like can be adopted. A detailed configuration of mounting head 40 will be described later.

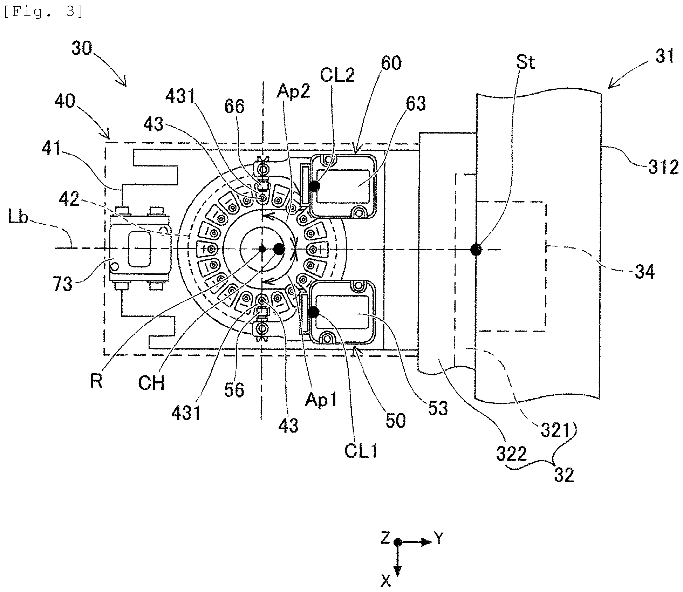

As described above, component transfer device 30 includes a first moving body (Y-slider 312) provided such as to be relatively movable with respect to base 2 in Y-direction, and a second moving body (X-slider 322 and mounting head 40) supported such as to be relatively movable with respect to Y-slider 312 in X-direction. Here, with the above-described configuration, the second moving body (X-slider 322 and mounting head 40) causes a side surface (rear surface of X-slider 322) of X-slider 322 in Y-direction to be supported by Y-slider 312. Hereinafter, a boundary portion at which Y-slider 312 supports X-slider 322 such as to be relatively movable with respect to each other is referred to as support section St (see Figs. 2 and 3).

Part camera 71, board camera 72, and head camera unit 73 are an imaging device of a digital type having an imaging element such as a CMOS. Part camera 71, board camera 72, and head camera unit 73 perform imaging based on a control signal, and transmits image data acquired by the imaging.

Part camera 71 is fixed to base 2 such that an optical axis is up in Z-direction. Part camera 71 is configured to be capable of imaging, from below, the component held by suction nozzle 44 of mounting head 40. Board camera 72 is provided on X-slider 322 of component transfer device 30 such that the optical axis is downward in Z-direction. Board camera 72 is configured to be capable of imaging board 90 from above.

As illustrated in Fig. 2, head camera unit 73 is provided on mounting head 40 and moves integrally with mounting head 40 associated with the movement of X-slider 322. Head camera unit 73 targets for imaging the components held in suction nozzle 44 and suction nozzle 44 attached to mounting head 40. Head camera unit 73 is configured to be capable of imaging suction nozzle 44 and the held component from a side.

Component mounting machine 1 executes the mounting process of mounting the component on board 90. The mounting process described above includes a process of repeating over multiple times a pick-and-place cycle for mounting the component at a predetermined position on board 90 by picking up the component supplied by component supply device 20. In the mounting process, component mounting machine 1 controls an operation of component transfer device 30 based on information output from various sensors, a result of the imaging process, and a control program stored in advance. Thus, positions and angles of multiple suction nozzles 44 supported by mounting head 40 are controlled.

### 2. Detailed Configuration of Mounting Head 40

As illustrated in Fig. 2, mounting head 40 has head main body 41 provided on X-slider 322. In the present embodiment, head main body 41 is detachably fixed to a front surface which is a vertical plane of X-slider 322. Mounting head 40 includes rotary head 42 which is rotatably provided around R-axis parallel with the vertical axis (Z-axis) with respect to head main body 41. Rotary head 42 slidably and rotatably holds multiple (for example, 20) syringes 43 in Z-direction at equal intervals in a circumferential direction on a circumference concentric with R-axis.

Syringe 43 is biased upward with respect to rotary head 42 by an elastic force of a spring (not illustrated). Thus, syringe 43 is located at a lifting end in a normal state where no external force is applied. Arm 431 extending outward in a radial direction is formed at an upper end portion of syringe 43. Suction nozzle 44, which is supplied with negative pressure air to pick up the component, is attached to a lower end portion of syringe 43. Thus, rotary head 42 supports multiple suction nozzles 44 such as to be capable of being lifted and lowered with respect to head main body 41, and rotatably around θ-axis passing through a center of syringe 43 parallel with R-axis.

Suction nozzle 44 is a holding member which is supplied with negative pressure air to pick up the component. Multiple suction nozzles 44 are angled to a predetermined angle (for example, a lifting and lowering angle of syringe 43) around R-axis by the rotation of rotary head 42 associated with the drive of R-motor 45. Mounting head 40 includes θ motor 46 fixed to head main body 41. All syringes 43 are coupled to an output shaft of θ motor 46 such as to be capable of transmitting a rotational force via multiple gears. Syringe 43 and suction nozzle 44 rotate (revolve) around θ-axis by an operation of θ motor 46, and a rotation angle and a rotation speed are controlled.

Mounting head 40 includes a lifting and lowering device for lifting and lowering suction nozzle 44 which is angled to a predetermined angle around R-axis by the rotation of rotary head 42. In the present embodiment, as illustrated in Fig. 3, mounting head 40 includes two of first lifting and lowering device 50 and second lifting and lowering device 60 for independently lifting and lowering two suction nozzles 44 which are angled to first predetermined angle Ap1 and second predetermined angle Ap2 around R-axis, respectively.

In the present embodiment, first predetermined angle Ap1 and second predetermined angle Ap2 are angles symmetrical to a vertical plane (in the present embodiment, YZ-plane) including reference line Lb connecting R-axis and support section St in a shortest. Specifically, first predetermined angle Ap1 and second predetermined angle Ap2 are angles forming 90 degrees from reference line Lb around R-axis. Further, first lifting and lowering device 50 and second lifting and lowering device 60 are arranged along the horizontal direction (in the present embodiment, X-direction) orthogonal to reference line Lb.

In the present embodiment, as illustrated in Fig. 2, first lifting and lowering device 50 has ball screw 51, nut member 52, Z-motor 53, Z-guide 54, Z-slider 55, and pusher 56. Ball screw 51 is rotatably provided on head main body 41. Nut member 52 engages with an outer circumference of ball screw 51 via a ball (not illustrated). Ball screw 51 is rotated associated with the drive of Z-motor 53, such that nut member 52 moves in Z-direction.

Z-guide 54 is fixed to head main body 41 such as to be parallel with ball screw 51, and slidably supports Z-slider 55. Z-slider 55 is fixed to nut member 52 and moves integrally with nut member 52 in Z-direction. Pusher 56 is provided on Z-slider 55. Pusher 56 comes into contact with arm 431 of syringe 43 that is angled to first predetermined angle Ap1 by the rotation of rotary head 42 of multiple syringes 43.

Pusher 56 presses syringe 43 downward in Z-direction against an elastic force of a spring of contacting syringe 43 to lower syringe 43. Thus, suction nozzle 44 attached to syringe 43 is integrally lifted and lowered with syringe 43. Syringe 43 and suction nozzle 44 are integrally lifted and lowered in Z-direction by the drive of Z-motor 53, and control the position in Z-direction and the movement speed.

Incidentally, second lifting and lowering device 60 has ball screw 61, nut member 62, Z-motor 63, Z-guide 64, Z-slider 65, and pusher 66. Here, second lifting and lowering device 60 is the same type as that of first lifting and lowering device 50 and is configured to be substantially symmetrical therewith in YZ-plane. Therefore, detailed description of second lifting and lowering device 60 is omitted. Signs in parentheses in Fig. 2 are signs of respective portions (61 to 66) of second lifting and lowering device 60 corresponding to respective portions (51 to 56) of first lifting and lowering device 50. Further, pusher 66 of second lifting and lowering device 60 comes into contact with arm 431 formed at an upper end portion of syringe 43 angled to second predetermined angle Ap2 of multiple syringes 43.

### 3. Operation Structure of Component Mounter 1

As described above, component mounting machine 1 mounts the component, which is picked up in the mounting process, on a predetermined position in board 90. At this time, it is necessary to secure a movable region of mounting head 40. On the other hand, downsizing of component mounting machine 1 is desired to improve an area productivity. Whereas, it is possible to secure a relatively wide movable region of mounting head 40 with respect to the width of base 2 in X-direction by a structure in which component transfer device 30 includes Y-slide device 31 of the suspension type.

Further, as illustrated in Fig. 3, mounting head 40 is formed in a rectangular shape in a view in R-axis direction so as not to substantially narrow the movable region described above, and is formed such that a length in the front-rear direction (Y-direction) orthogonal to the conveyance direction is larger than the width of board 90 in the conveyance direction (X-direction). As described above, the movable region in X-direction in component mounting machine 1 can be easily secured by adopting the vertically long shape to mounting head 40 and it is possible to improve the area productivity as a result.

Incidentally, in mounting head 40, when the lifting and lowering device (first lifting and lowering device 50 and second lifting and lowering device 60) for lifting and lowering suction nozzle 44 is operated, the movable section of the lifting and lowering device is relatively moved or relatively rotated with respect to head main body 41. Then, in mounting head 40, vibration associated with the lifting and lowering of suction nozzle 44 occurs. Component mounting machine 1 controls the component to be picked up or mounted after the vibration is sufficiently attenuated to ensure the accuracy of the mounting process. Therefore, the attenuation time is long when the vibration described above is large, and there is a possibility that the time required for the mounting process is affected.

Against such circumstances, it was found that a positional relationship between support section St in which first moving body (Y-slider 312) supports the second moving body including mounting head 40 and centroid position CH of mounting head 40 affects the magnitude of the occurring vibration. Specifically, the farther centroid position CH of mounting head 40 is from support section St, the greater the occurring vibration is increased, and naturally, the attenuation time becomes longer. In addition, the "attenuation time" described above corresponds to a time required from the occurrence of vibration to a predetermined amplitude or less.

In particular, in the present embodiment, since a vertically long shape is adopted in mounting head 40 and it is the structure in which vibration is relatively likely to occur, it is desired to suppress the occurrence of vibration associated with the operation of the lifting and lowering device. Therefore, mounting head 40 of the present embodiment adopts a structure in which centroid position CH of mounting head 40 is brought close to a support section St side as compared with that having the conventional structure. Specifically, the lifting and lowering device (first lifting and lowering device 50 and second lifting and lowering device 60) of mounting head 40 is provided on head main body 41 such that the centroid position of the lifting and lowering device is located between R-axis and support section St.

More specifically, as illustrated in Fig. 3, first lifting and lowering device 50 is provided such that centroid position CL1 is located between R-axis and support section St in Y-axis direction. Similarly, second lifting and lowering device 60 is provided such that centroid position CL2 is located between R-axis and support section St in Y-axis direction. Further, in the present embodiment, first lifting and lowering device 50 and second lifting and lowering device 60 are provided in head main body 41, such that the movable section (ball screw 51, nut member 52, Z-slider 55, pusher 56, and the like) is located between R-axis and support section St in Y-direction.

Here, first lifting and lowering device 50 and second lifting and lowering device 60 are heavy objects that exhibit a large weight ratio in the configuration components of mounting head 40. In particular, the movable member of the lifting and lowering device and a member for supporting the movable section are likely to be heavy objects due to circumstances such as ensuring a necessary strength. Therefore, by disposing first lifting and lowering device 50 and second lifting and lowering device 60 as described above, centroid position CH of mounting head 40 can inevitably approach support section St.

Thus, for example, as compared with the configuration in which the lifting and lowering device is disposed on an opposite side of support section St with respect to R-axis as with conventional art, it is possible to suppress the occurrence of vibration associated with the operation of the lifting and lowering device. As a result, since the attenuation time of the vibration can be reduced, it is possible to improve the accuracy of the mounting process and to shorten the time required for the mounting process. Further, the operation structure as described above becomes a stable structure by shortening the distance between centroid position CH of mounting head 40 and support section St, and for example, the occurrence of vibration associated with the horizontal movement of mounting head 40 can be similarly suppressed regardless of the operation of the lifting and lowering device.

### 4. Effects by Configuration of Embodiment

The component mounting machine 1 described above includes base 2, the first moving body (Y-slider 312) provided relatively movable in the first direction of the horizontal direction with respect to base 2, and the second moving body (X-slider 322 and mounting head 40) of which the side surface in the first direction is supported by the first moving body relatively movable with respect to the first moving body in the second direction of the horizontal direction intersecting with the first direction, and which has mounting head 40 for holding the component to be mounted on board 90.

Mounting head 40 includes head main body 41 provided on the second moving body, rotary head 42 which is rotatably provided around R-axis parallel with the vertical axis with respect to head main body 41 and supports the multiple holding members (suction nozzles 44) that hold the components such as to be capable of being lifted and lowered with respect to head main body 41, and the lifting and lowering device (first lifting and lowering device 50 and second lifting and lowering device 60) which lifts and lowers the holding member angled to the predetermined angle (first predetermined angle Ap1 and second predetermined angle Ap2) around R-axis by the rotation of rotary head 42, and is provided on head main body 41 such that centroid position (CL1 and CL2) of the lifting and lowering device is located between R-axis and support section St in which the first moving body supports the second moving body such as to be relatively movable.

In addition, mounting head 40 includes head main body 41 provided on the second moving body, rotary head 42 which is rotatably provided around R-axis parallel with the vertical axis with respect to head main body 41 and supports the multiple holding members (suction nozzles 44) that hold the components such as to be capable of being lifted and lowered with respect to head main body 41, and the lifting and lowering device (first lifting and lowering device 50 and second lifting and lowering device 60) which lifts and lowers the holding member angled to the predetermined angle (first predetermined angle Ap1 and second predetermined angle Ap2) around R-axis by the rotation of rotary head 42 by operating the movable section (51, 52, 55, 56) which is relatively moved or relatively rotated with respect to head main body 41, and is provided on head main body 41 such that the movable section is located between R-axis and support section St in which the first moving body supports the second moving body such as to be relatively movable.

Thus, by providing first lifting and lowering device 50 and second lifting and lowering device 60 on head main body 41 such as to be located between R-axis and support section St, centroid position CH of mounting head 40 inevitably approaches support section St. Thus, it is possible to suppress the vibration occurring associated with the operation of first lifting and lowering device 50 and second lifting and lowering device 60. As a result, since the time until the above-described vibration is attenuated to a predetermined amplitude is faster, the accuracy of the mounting process can be easily secured and it is possible to shorten the time required for the mounting process.

### 5. Modified Examples of Embodiment

### 5-1. Mounting Head 40

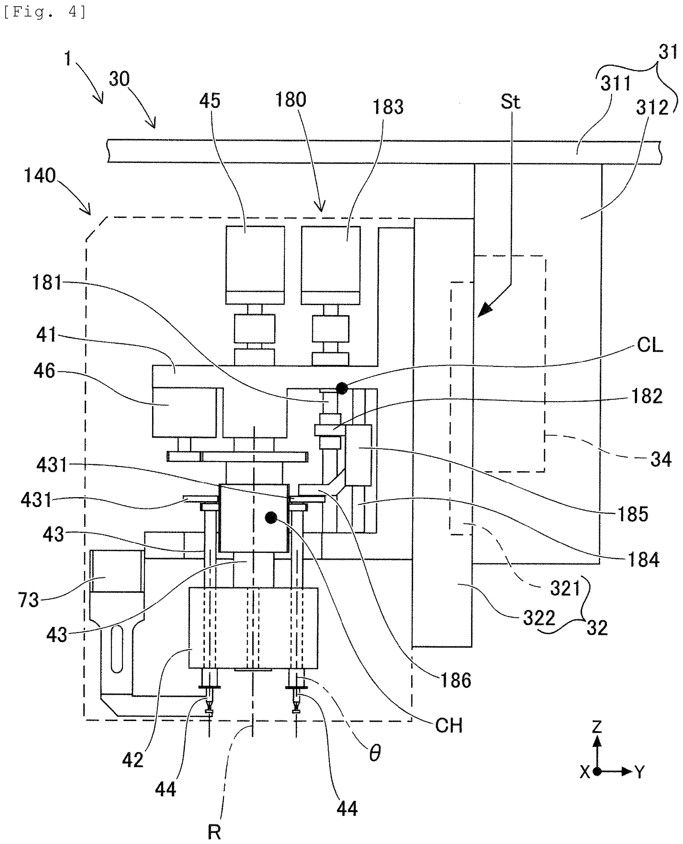

In the embodiment, mounting head 40 is configured to include two lifting and lowering devices (first lifting and lowering device 50 and second lifting and lowering device 60). Whereas, the mounting head may be configured to include one lifting and lowering device. Specifically, as illustrated in Fig. 4, mounting head 140 includes one lifting and lowering device 180. Lifting and lowering device 180 of mounting head 140 described above includes ball screw 181, nut member 182, Z-motor 183, Z-guide 184, Z-slider 185, and pusher 186.

Here, lifting and lowering device 180 is provided on head main body 41 such that centroid position CL of lifting and lowering device 180 is located between R-axis and support section St. Further, lifting and lowering device 180 is provided on head main body 41 such that the movable section (ball screw 181, nut member 182, Z-slider 185, pusher 186, and the like) is located between R-axis and support section St. According to the above-described configuration, the same effects as those of the embodiment can be obtained. In addition to the above, the mounting head may be configured to include three or more lifting and lowering devices. In such a configuration, at least one or more lifting and lowering devices are provided on head main body 41 as described above, thereby achieving the same effects as those of the embodiment.

In the embodiment and the modified examples, the lifting and lowering device (50, 60, and 180) is configured to have the ball screw mechanism for lifting and lowering suction nozzle 44 by rotating ball screws 51, 61, and 181. Whereas, in place of the ball screw mechanism, a linear motion mechanism using a linear motor or the like may be applied to the lifting and lowering device. Incidentally, in a case where the lifting and lowering device is the linear motion mechanism using the linear motor, a motor block relatively moving in Z-direction with respect to a motor shaft corresponds to the movable section of the lifting and lowering device.

In addition, in the embodiment, mounting head 40 is detachably fixed to X-slider 322, and constitutes the second moving body in component transfer device 30 together with X-slider 322. Whereas, for example, the head main body of the mounting head may be integrally formed with the X-slider, and the mounting head and the X-slider may constitute the second moving body.

### 5-2. Component Mounter 1

In the embodiment, in component transfer device 30 of component mounting machine 1, the first direction of the horizontal direction is referred to as Y-direction, and the second direction of the horizontal direction is referred to as X-direction. Whereas, the component transfer device may have a configuration, such that the first moving body is relatively movable with respect to base 2 in X-direction, and the second moving body is relatively movable with respect to the first moving body in Y-direction.

In addition, in the embodiment, an aspect in which the holding member for holding the component is suction nozzle 44 is exemplified. Whereas, the holding member may be a chuck or the like for clamping the component. Also in such a configuration, the same effects as those in the embodiment can be obtained.

### Reference Signs List

1: component mounting machine, 2: base, 30: component transfer device, 31: Y-slide device, 311: Y-rail, 312: Y-slider (first moving body), 32: X-slide device, 321: X-rail, 322: X-slider (second moving body), 40, 140: mounting head (second moving body), 41: head main body, 42: rotary head, 43: syringe, 431: arm, 44: suction nozzle (holding member), 50: first lifting and lowering device, 51: ball screw, 60: second lifting and lowering device, 61: ball screw, 180: lifting and lowering device, 181: ball screw, 90: board, CL1: centroid position (of first lifting and lowering device), CL2: centroid position (of second lifting and lowering device), CL: centroid position (of lifting and lowering device), CH: centroid position (of mounting head), St: support section

## Claims

1. A component mounting machine comprising:
a base;
a first moving body which is provided to be relatively movable with respect to the base in a first direction of a horizontal direction; and
a second moving body, a side surface of which in the first direction being supported by the first moving body, which is capable of being relatively movable with respect to the first moving body in a second direction of the horizontal direction intersecting with the first direction, and which has a mounting head holding a component to be mounted on a board,
wherein the mounting head includes
a head main body provided on the second moving body,
a rotary head being rotatably provided around an R-axis parallel with a vertical axis with respect to the head main body, the rotary head being configured to support multiple holding members, each of which being capable of holding the component and being lifted and lowered with respect to the head main body, and
a lifting and lowering device which lifts and lowers the holding member angled to a predetermined angle around the R-axis by rotation of the rotary head, the lifting and lowering device being provided on the head main body such that a centroid position of the lifting and lowering device is located between the R-axis and a support section in which the first moving body supports the second moving body in a manner of moving relatively.

2. The component mounting machine according to Claim 1,
wherein the mounting head includes two lifting and lowering devices for independently lifting and lowering two holding members angled to a first predetermined angle and a second predetermined angle around the R-axis.

3. The component mounting machine according to Claim 2,
wherein the first predetermined angle and the second predetermined angle are angles symmetrical to a vertical plane including a reference line connecting the R-axis and the support section, and
wherein two lifting and lowering devices are arranged along a horizontal direction orthogonal to the reference line.

4. The component mounting machine according to any one of Claims 1 to 3,
wherein the lifting and lowering device has a ball screw mechanism for lifting and
lowering the holding member by rotating a ball screw.

5. The component mounting machine according to any one of Claims 1 to 4,
wherein the mounting head is formed in a rectangular shape in a view in a direction of the R-axis, and is formed such that a length in a front-rear direction orthogonal to a conveyance direction of the board is longer than a width in the conveyance direction.

6. The component mounting machine according to any one of Claims 1 to 5, further comprising:
a suspension type slide device having multiple rails for supporting the first moving body in a suspended state.

7. The component mounting machine according to any one of Claims 1 to 6,
wherein the lifting and lowering device lifts and lowers the holding member by operating a movable section which relatively moves or relatively rotates with respect to the head main body, and is provided on the head main body such that the movable section is located between the R-axis and the support section.

8. A component mounting machine comprising:
a base;
a first moving body which is provided to be relatively movable with respect to the base in a first direction of a horizontal direction; and
a second moving body, a side surface of which in the first direction being supported by the first moving body, which is capable of being relatively movable with respect to the first moving body in a second direction of the horizontal direction intersecting with the first direction, and which has a mounting head holding a component to be mounted on a board,
wherein the mounting head includes
a head main body provided on the second moving body,
a rotary head being rotatably provided around an R-axis parallel with a vertical axis with respect to the head main body, the rotary head being configured to support multiple holding members, each of which being capable of holding the component and being lifted and lowered with respect to the head main body, and a lifting and lowering device which lifts and lowers the holding member angled to a predetermined angle around the R-axis by rotation of the rotary head by operating a movable section which relatively moves or relatively rotates with respect to the head main body, the lifting and lowering device being provided on the head main body such that the movable section is located between the R-axis and a support section in which the first moving body supports the second moving body in a manner of moving relatively.
